# EUROPEAN PATENT APPLICATION

(11) **EP 4 707 033 A1**
(43) Date of publication of application: **11.03.2026**
(21) Application number: 24199046.4
(22) Date of filing: 06.09.2024
(51) Int. Cl.: B60L 3/12, B60L 53/10, B60L 53/62, B60L 53/63, B60L 53/64, B60L 53/66, B60L 53/68, B60L 58/12, B60L 58/13, B60L 58/16, B60L 53/14, G01R 31/382, G01R 31/392, G06Q 50/06

(54) **A COMPUTER SYSTEM AND METHOD FOR CHARGING**

(71) Applicant: Volvo Truck Corporation, 405 08 Göteborg (SE)
(72) Inventor: NORDHOLM, LINUS, Askim (SE); SMIDEBRANT, TOBIAS, Göteborg (SE); SINGH, GURPREET, Västra Frölunda (SE); WILHELMSSON, MARTIN, Torslanda (SE)
(74) Representative: Ström & Gulliksson AB

(57) **Abstract**

A computer system comprising processing circuitry configured to: obtain a charging request for a rechargeable energy storage system (11) of a vehicle (1); select a charging strategy based on a total cost of ownership (TCO) of the rechargeable energy storage system (11); and activate charging of the rechargeable energy storage system (11) according to the selected charging strategy.

## Description

### TECHNICAL FIELD

The disclosure relates generally to charging of rechargeable energy storage systems. In particular aspects, the disclosure relates to computer systems and method for charging. The disclosure can be applied to heavy-duty vehicles, such as trucks, buses, and construction equipment, among other vehicle types. Although the disclosure may be described with respect to a particular vehicle, the disclosure is not restricted to any particular vehicle.

### BACKGROUND

Many vehicles are provided with rechargeable energy storage systems, such as batteries. These batteries may be configured to provide electrical power to various equipment, most typically one or more electric propulsion motors. The charging strategy for keeping a sufficient energy level in these batteries is typically selected based on charging need and charging availability. While such approach will likely be successful in terms of allowing the vehicle to travel satisfactory, there is a need for reducing battery ageing.

### SUMMARY

According to a first aspect of the disclosure, a computer system is provided. The computer system comprises processing circuitry configured to obtain a charging request for a rechargeable energy storage system of a vehicle, select a charging strategy based on a total cost of ownership of the rechargeable energy storage system, and activate charging of the rechargeable energy storage system according to the selected charging strategy. The first aspect of the disclosure may seek to reduce ageing of the rechargeable energy storage system. A technical benefit may include a more intelligent approach to charging of batteries, allowing several parameters that affect the battery performance to be taken into account with the aim of considering the total cost of ownership, not only the desire to achieve the sufficient charging level.

Optionally in some examples, including in at least one preferred example, the processing circuitry is further configured to obtain the charging request based on a driver request, a charging availability, and/or a current state of charge of the rechargeable energy storage system. A technical benefit may include using available parameters for initiating the charging strategy selection process.

Optionally in some examples, including in at least one preferred example, the processing circuitry is further configured to obtain an electricity price, and determine the total cost of ownership based on the obtained electricity price. A technical benefit may include adding the charging cost when calculating the total cost of ownership, thereby improving the accuracy and allowing a more correct selection of the charging strategy.

Optionally in some examples, including in at least one preferred example, the processing circuitry is further configured to obtain a charging availability and/or a charging capability, and determine the total cost of ownership based on the obtained charging availability and/or the obtained charging capability. A technical benefit may include a further improvement in designing and selecting an optimized charging strategy.

Optionally in some examples, including in at least one preferred example, the processing circuitry is further configured to obtain a requested departure time and a requested itinerary for the vehicle, and determine the total cost of ownership based on the obtained requested departure time and/or the requested itinerary. A technical benefit may include a yet further improvement in designing and selecting an optimized charging strategy.

Optionally in some examples, including in at least one preferred example, the processing circuitry is further configured to obtain a state of health behaviour for the rechargeable energy storage system, and determine the total cost of ownership based on the obtained state of health behaviour. A technical benefit may include an even further improvement in designing and selecting an optimized charging strategy.

Optionally in some examples, including in at least one preferred example, the processing circuitry is further configured to determine a plurality of charging strategies and an associated total cost of ownership for each determined charging strategy; wherein the selected charging strategy is associated with the lowest total cost of ownership of the rechargeable energy storage system. A technical benefit may include applying an optimization algorithm for charging the vehicle, thereby reducing the total cost of ownership.

Optionally in some examples, including in at least one preferred example, the processing circuitry is further configured to obtain the charging request based on a driver request, a charging availability, and/or a current state of charge of the rechargeable energy storage system; obtain an electricity price, a charging availability and/or a charging capability, a requested departure time and a requested itinerary for the vehicle, a state of health behaviour for the rechargeable energy storage system, and a current vehicle state, and determine the total cost of ownership based on the obtained electricity price, based on the obtained charging availability and/or the obtained charging capability, based on the obtained requested departure time and/or the requested itinerary, based on the obtained state of health behaviour, and based on the current vehicle state, wherein the processing circuitry is further configured to: determine a plurality of charging strategies and an associated total cost of ownership for each determined charging strategy; wherein the selected charging strategy is associated with the lowest total cost of ownership of the rechargeable energy storage system. A technical benefit may include applying a comprehensive approach to charging, considering a plurality of different parameters that may affect the ageing, and thereby the total cost of ownership, for the rechargeable energy storage system.

According to a second aspect of the disclosure, a vehicle is provided. The vehicle comprises a computer system according to the first aspect. The second aspect of the disclosure may seek to reduce the operational cost of the vehicle by reducing ageing of the rechargeable energy storage system. A technical benefit may include a more intelligent approach to charging of batteries, allowing several parameters that affect the battery performance to be taken into account with the aim of considering the total cost of ownership, not only the desire to achieve the sufficient charging level.

Optionally in some examples, including in at least one preferred example, the vehicle further comprises at least one rechargeable energy storage system, such as at least one battery. A technical benefit may include applying cost reduction to existing and onboard components of the vehicle, as well as decreasing the downtime of the vehicle due to excessive service and maintenance of the vehicle.

According to a third aspect of the disclosure, a computer-implemented method is provided. The computer-implemented method comprises obtaining, by processing circuitry of a computer system, a charging request for a rechargeable energy storage system of a vehicle; selecting, by the processing circuitry, a charging strategy based on a total cost of ownership of the rechargeable energy storage system; and activating, by the processing circuitry, charging of the rechargeable energy storage system according to the selected charging strategy. The third aspect of the disclosure may seek to reduce the operational cost of the vehicle by reducing ageing of the rechargeable energy storage system. A technical benefit may include a more intelligent approach to charging of batteries, allowing several parameters that affect the battery performance to be taken into account with the aim of considering the total cost of ownership, not only the desire to achieve the sufficient charging level.

Optionally in some examples, including in at least one preferred example, the method further comprises obtaining, by the processing circuitry, the charging request based on a driver request, a charging availability, and/or a current state of charge of the rechargeable energy storage system. A technical benefit may include using available parameters for initiating the charging strategy selection process.

Optionally in some examples, including in at least one preferred example, the method further comprises obtaining, by the processing circuitry, an electricity price, and determining, by the processing circuitry, the total cost of ownership based on the obtained electricity price. A technical benefit may include adding the charging cost when calculating the total cost of ownership, thereby improving the accuracy and allowing a more correct selection of the charging strategy.

Optionally in some examples, including in at least one preferred example, the method further comprises obtaining, by the processing circuitry, a charging availability and/or a charging capability, and determining, by the processing circuitry, the total cost of ownership based on the obtained charging availability and/or the obtained charging capability. A technical benefit may include a further improvement in designing and selecting an optimized charging strategy.

Optionally in some examples, including in at least one preferred example, the method further comprises obtaining, by the processing circuitry, a requested departure time and a requested itinerary for the vehicle, and determining, by the processing circuitry, the total cost of ownership based on the obtained requested departure time and/or the requested itinerary. A technical benefit may include a yet further improvement in designing and selecting an optimized charging strategy.

Optionally in some examples, including in at least one preferred example, the method further comprises obtaining, by the processing circuitry, a state of health behaviour for the rechargeable energy storage system, and determining, by the processing circuitry, the total cost of ownership based on the obtained state of health behaviour. A technical benefit may include an even further improvement in designing and selecting an optimized charging strategy.

Optionally in some examples, including in at least one preferred example, the method further comprises obtaining, by the processing circuitry, a current vehicle state for the vehicle, and determining, by the processing circuitry, the total cost of ownership based on the obtained vehicle state. A technical benefit may include a yet further improvement in designing and selecting an optimized charging strategy.

Optionally in some examples, including in at least one preferred example, the method further comprises determining, by the processing circuitry, a plurality of charging strategies and an associated total cost of ownership for each determined charging strategy; wherein the selected charging strategy is associated with the lowest total cost of ownership of the rechargeable energy storage system. A technical benefit may include applying an optimization algorithm for charging the vehicle, thereby reducing the total cost of ownership.

According to a fourth aspect of the disclosure, a computer program product is provided. The computer program product comprises program code for performing, when executed by the processing circuitry, the method according to the third aspect. The fourth aspect of the disclosure may seek to reduce the operational cost of the vehicle by reducing ageing of the rechargeable energy storage system. A technical benefit may include a more intelligent approach to charging of batteries, allowing several parameters that affect the battery performance to be taken into account with the aim of considering the total cost of ownership, not only the desire to achieve the sufficient charging level.

According to a fifth aspect of the disclosure, a non-transitory computer-readable storage medium is provided. The non-transitory computer-readable storage medium comprises instructions, which when executed by the processing circuitry, cause the processing circuitry to perform the method according to the third aspect. The fourth aspect of the disclosure may seek to reduce the operational cost of the vehicle by reducing ageing of the rechargeable energy storage system. A technical benefit may include a more intelligent approach to charging of batteries, allowing several parameters that affect the battery performance to be taken into account with the aim of considering the total cost of ownership, not only the desire to achieve the sufficient charging level.

There are also disclosed herein computer systems, control units, code modules, computer-implemented methods, computer readable media, and computer program products associated with the above discussed technical benefits.

### BRIEF DESCRIPTION OF THE DRAWINGS

**FIG. 1** is an exemplary side view of a vehicle according to an example.
**FIG. 2** is a system diagram of a vehicle according to an example.
**FIG. 3** is an exemplary system diagram of a charging control system for a rechargeable energy storage system according to an example.
**FIGS. 4A-D** **are** exemplary diagrams of charging strategies according to different examples.
**FIG. 5** is an exemplary system diagram of a charging control system according to an example.
**FIG. 6** is a flow chart of an exemplary method to charge a rechargeable energy storage system according to an example.
**FIG. 7** is a schematic diagram of an exemplary computer system for implementing examples disclosed herein, according to an example.

### DETAILED DESCRIPTION

The detailed description set forth below provides information and examples of the disclosed technology with sufficient detail to enable those skilled in the art to practice the disclosure.

The examples presented herein provide a solution to the problem of ageing of rechargeable energy storage systems, such as batteries. The energy level of the rechargeable energy storage system contributes to ageing, i.e. a time dependent reduction of the usable capability. It is suggested to address this issue by applying a novel approach to charging. When charging is needed, a plurality of parameters are assessed in order to define a charging strategy which not only fulfills the desired requirements in terms of energy level, but also is designed to keep the total cost of ownership of the rechargeable energy storage system as low as possible. Since ageing will eventually require service or even replacement of the rechargeable energy storage system, it is desired to minimize ageing as much as possible thereby increasing the runtime.

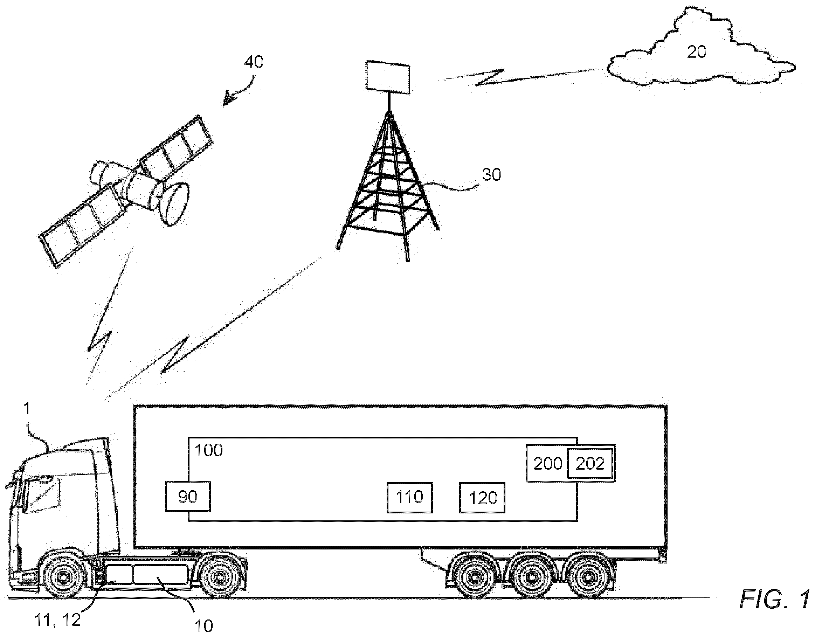

**FIG. 1** is an exemplary view of a vehicle **1** according to one example. The vehicle **1** comprises at least one electrical machine **10** used to propel the vehicle **1.** The at least one electrical machine **10** is powered by at least one rechargeable energy storage system **11** configured to provide electrical energy to the one or more electrical machines **10.**

The at least one rechargeable energy storage system **12** is controlled by a charging controller **12** being configured to act as a master controller for charging of the at least one rechargeable energy storage system **12.**

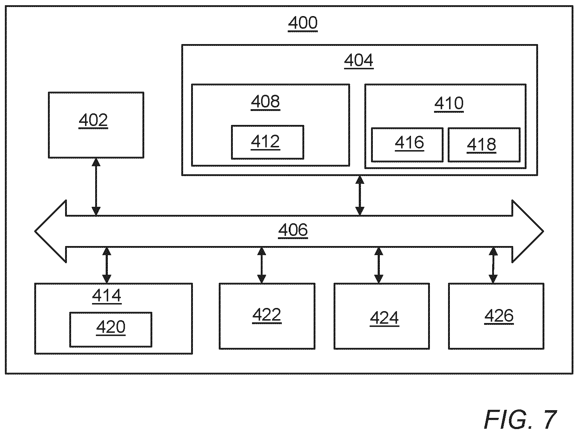

The vehicle **1** comprises, at least to some extent, processing circuitry **110** forming part of a computer system **100** (see **FIG. 7**)**.** The processing circuitry **110** is configured to implement a charging control system **200** which is configured to be operatively connected to the charging controller **12.**

The vehicle **1** may further comprise communications circuitry **90** configured to receive and/or send communications. The communications circuitry **90** may be configured to enable the vehicle **1** to communicate with one or more external devices or systems such as a cloud server **20.** The communication with the external devices or systems may be directly or via a communications interface such as a cellular communications interface **30,** such as a radio base station. The cloud server **20** may be any suitable cloud server exemplified by, but not limited to, Amazon Web Services (AWS), Microsoft Azure, Google Cloud Platform (GCP), IBM Cloud, Oracle Cloud Infrastructure (OCI), DigitalOcean, Vultr, Linode, Alibaba Cloud, Rackspace etc. The communications interface may be a wireless communications interface exemplified by, but not limited to, Wi-Fi, Bluetooth, Zigbee, Z-Wave, LoRa, Sigfox, 2G (GSM, CDMA), 3G (UMTS, CDMA2000), 4G (LTE), 5G (NR) etc. The communication circuitry **90** may, additionally or alternatively, be configured to enable the vehicle **1** to be operatively connected to a Global Navigation Satellite System (GNSS) **40** exemplified by, but not limited to, global positioning system (GPS), Globalnaya Navigatsionnaya Sputnikovaya Sistema (GLONASS), Galileo, BeiDou Navigation Satellite System, Navigation with Indian Constellation (NavIC) etc. The vehicle **1** may for example be configured to utilize data obtain from the GNSS **40** to determine a geographical location of the vehicle **1.**

The vehicle **1** in **FIG. 1** comprises the computer system **100** and the charging control system **200.** The computer system **100** may be operatively connected to the charging control system **200** and optionally to the communications circuitry **90** of the vehicle **1.** The computer system **100** comprises processing circuitry **110.** The computer system **100** may comprise a storage device **120,** advantageously a non-volatile storage device such as a hard disk drives (HDDs), solid-state drives (SSDs) etc. In some examples, the storage device **120** is operatively connected to the computer system **100.** The charging control system **200** may comprise charging control system processing circuitry **202;** the charging control system processing circuitry **202** may be part of the processing circuitry **110** of the computer system **100.**

The at least one rechargeable energy storage system **11** may comprise one or more battery packs. Each battery pack may comprise one or more battery modules, each of which comprises a plurality of battery cells.

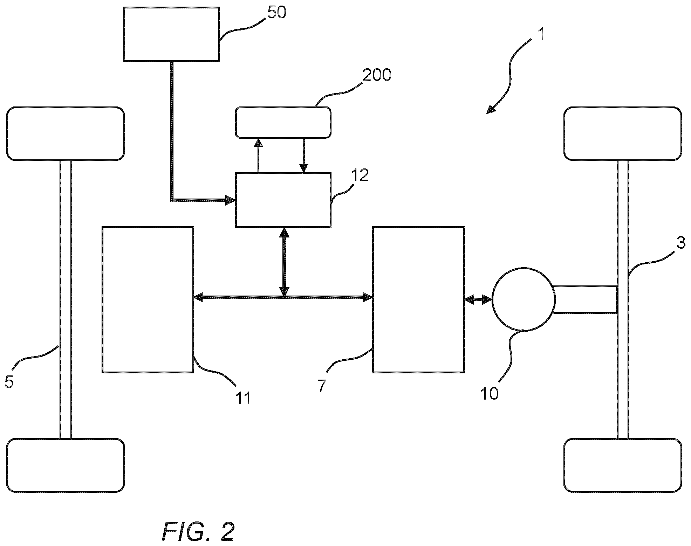

**FIG. 2** is an exemplary system diagram of a vehicle **1** according to an example. The vehicle **1** comprises a front axle **3** and at least one further axle **5.** At least one of the axles **3, 5** is driven by an electrical machine **10.** The electrical machine **10** receives and transmits electrical power to and from one or more rechargeable energy storage systems **11,** here represented by a battery pack. A charging controller **12,** which is connectable to an external charger **50,** is provided to control the electrical power delivered from (or supplied to) the battery pack **11.** Typically an inverter 7 is connected between the electrical machine **10** and the battery pack **11.** A charging control system **200** is operatively connected to the charging controller **12,** causing the charging controller **12** to implement a desired charging strategy when the vehicle **1** is connected to the external charger **50.**

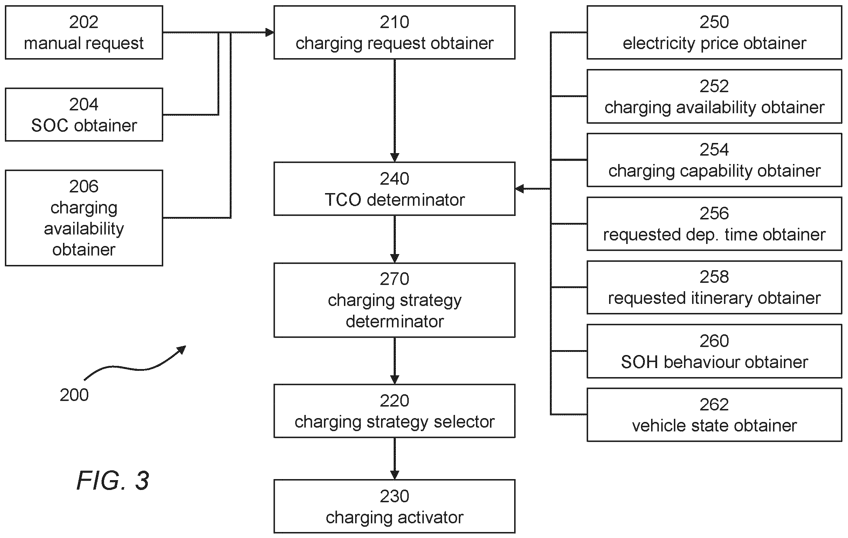

**FIG. 3** is an exemplary system diagram of a charging control system **200** according to an example. The charging control system **200** comprises a charging request obtainer **210.** The charging request obtainer **210** is configured to obtain a charging request. The charging request obtainer **210** may be configured to receive request data from, as illustrated in **FIG. 3****,** a manual request obtainer **202,** a state-of-charge (SOC) obtainer **204,** and/or a charging availability obtainer **206.**

The manual request obtainer **202** may for example be configured to detect a manual request to initiate charging (typically requiring the associated vehicle being connected to an external charger **50**), and to transmit the manual request to the charging request obtainer **210.**

The SOC obtainer **204** may be configured to detect the current SOC level to be below a certain minimum level, or threshold, that would require charging. As for the manual request obtainer **202,** the SOC obtainer **204** may be configured to transmit the request to the charging request obtainer **210.**

The charging availability obtainer **206** may be configured to detect that there is an opportunity of available charging capability. Such situation may e.g. occur when the associated vehicle is approaching a charging station. Another situation may be when the associated vehicle is already connected to an external charger **50** with no grid power supplied to, and there is a sudden turn on of the grid power. The charging availability obtainer **206** may further be configured to transmit the request to the charging request obtainer **210.**

Notably, the manual request obtainer **202,** the SOC obtainer **204,** and/or the charging availability obtainer **206** may operate in cooperation. For example, the manual request obtainer **202** may detect a manual request, but the request will not be transmitted to the charging request obtainer **210** until the SOC obtainer **204** and/or the charging availability obtainer **206** also obtains data corresponding to a charging request.

The charging control system **200** further comprises a total cost of ownership (TCO) determinator **240.** The TCO determinator **240** is configured to determine the TCO of the rechargeable energy storage system **11** based on the charging request obtained by the charging request obtainer **210** as well as a number of parameters which may, to large or small extent, affect the total cost of ownership.

Such parameters may for example comprise the electricity price, the charging availability, the charging capability, the requested departure time, the requested itinerary of the associated vehicle, the state-of-health SOH behavior, and the current vehicle state. These parameters may be obtained by an electricity price obtainer **250,** a charging availability obtainer **252,** a charging capability obtainer **254,** a requested departure time obtainer **256,** a requested itinerary obtainer **258,** a SOH behavior obtainer **260,** and a vehicle state obtainer **262.**

The electricity price obtainer **250** may be configured to receive data corresponding to the current electricity price of the specific external charger **50** considered to provide the desired charging. Such data may be wireless data.

The charging availability obtainer **252** may be a charging availability obtainer similar to what has been described with reference to reference numeral **206.** In other examples, more data is obtained such as the current usage of an approaching charging station comprising one or more external chargers **50.** Hence, the charging availability obtainer **252** may be configured to determine an expected downtime if the available charger **50** is used for charging.

The charging capability obtainer **254** may be configured to obtain data corresponding to the capability of the external charger **50** considered for the desired charging. Such capability may be determined in terms of kW, estimated charging time, estimated downtime (potentially also including the time required to reach the charger **50**), etc.

The requested departure time obtainer **256** may be configured to obtain data corresponding to the requested departure time. For example, the associated vehicle **1** may be connected to the external charger **50** in the evening, while the requested departure time is not until the morning. The requested departure time may be used to determine other parameters such as when charging must be started and at what power.

The requested itinerary obtainer may be configured to obtain data corresponding to the requested itinerary. For example, the itinerary may include data related to a ferry transport only departing at specific times, with or without the option of the vehicle to be charged during such ferry transport. Itinerary data may be used to determine associated parameters such as vehicle downtime.

The SOH behavior obtainer **260** may be configured to obtain data corresponding to the current SOH behavior of the rechargeable energy storage system **11.** For example, SOH behavior data may comprise information of how much the rechargeable energy storage system **11** has been charged during previous charging cycles, as well as data concerning previous discharging processes. Yet further, the SOH behavior data may comprise information (calculated or estimated) related to the current SOH of the rechargeable energy storage system **11.**

The vehicle state obtainer **262** may be configured to obtain data corresponding to the current state of the associated vehicle. For example, such data may include information representing current load, weight, and/or required torque. Such information may e.g. be related to the required level of power discharge from the rechargeable energy storage system.

One or more of the above-mentioned parameters are communicated to the TCO determinator **240,** which is in further communication with a charging strategy determinator **270.** The charging strategy determinator **270** is configured to use the data from the TCO determinator **240** in order to determine at least one charging strategy based on the determined TCO. As a plurality of parameters may be considered when determining the TCO, preferably the charging strategy determinator **270** is configured to determine a plurality of charging strategies, each charging strategy being associated with specific parameter values resulting in a specific TCO for each determined charging strategy.

The charging control system **200** further comprises a charging strategy selector 220. The charging strategy selector **220** is configured to access the one or more charging strategies determined by the charging strategy determinator **270,** and to select a specific charging strategy being associated with the lowest TCO.

The charging control system **200** further comprises a charging activator **230.** The charging activator **230** is configured to activate charging of the rechargeable energy storage system **11,** and to make sure that charging is performed according to the selected charging strategy obtained by the charging strategy selector **220.**

Typically, the charging strategy defines, from a starting point in time to an ending point in time, the charging power to be used. The above mentioned parameters may set constraints to what charging strategies that may be applicable.

In one example, one or more of the above mentioned parameters may be used to define cost-related parameters, which in turn are used to determine the total cost of ownership. For example, the electricity price may be used to determine a charging cost **CC.** The charging cost may further be determined based on the requested itinerary, and/or the requested departure time. The last parameters may especially contribute to the charging cost if the electricity price is fluctuating. For example, if the vehicle, having an almost empty battery, is connected to an external charger **50** in the evening but the requested departure time is not until the morning and the itinerary requires a 50% SOC of the battery, the charging cost will vary dependent on charging strategy. It is noted that also the current vehicle state may be used for determining how much charging is needed. Assuming that the electricity price is at its lowest in the middle of the night, the charging cost **CC** will be minimized if the entire charging is performed when the low price is applicable. On the other hand, if the itinerary and/or the requested departure time requires immediate full power charging, these parameters are constraints to the optimization in charging cost **CC.**

The same and/or other parameters may be used to determine a downtime cost **DC.** The downtime cost **DC** may be determined to represent an assumed cost for keeping the vehicle at standstill during charging. Hence, a fast charging (e.g. corresponding to using a nearby charger **50,** charging at maximum available power, avoiding excessive charging) will minimize the downtime of the vehicle and consequently also minimizing the downtime cost **DC**

One or more parameters may be used to determine an ageing cost **AC.** The ageing cost **AC** is preferably an estimation of how the charging affects battery ageing, and the cost associated with such estimated ageing. Ageing may for example be represented by a percentage value, i.e. how the charging affects the state of health (SOH) of the rechargeable energy storage system **11.** Since the SOH will eventually degrade to a level requiring replacement, the cost for such replacement may be used, possibly in cooperation with a downtime cost associated with the vehicle 1 being subject to service, to assign the ageing cost **AC** to a specific charging.

In one example, the total cost of ownership TCO for a specific charging strategy is determined as the sum of the charging cost **CC,** the downtime cost **DC,** and the ageing cost **AC,** i.e. **TCO** = **CC** + **DC** + **AC.** In some examples the TCO is determined as the sum of at least two of **CC, DC,** and **AC.** It should be noted that the above cost-related parameters **CC, DC,** and **AC** may be contradictory. While a certain charging strategy may be designed to minimize charging cost, the same charging strategy will result in a non-minimum downtime cost and/or non-minimum ageing cost. Therefore, in many cases the selected charging strategy will be a compromise of the cost-elated parameters.

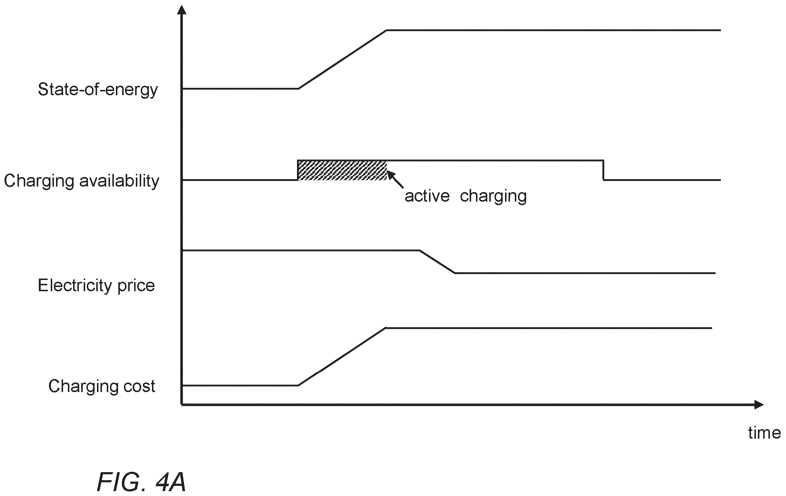

**FIGS. 4A-D** show different examples of charging strategies that may be determined by the charging strategy determinator **270** and considered by the charging strategy selector **220.** In **FIG. 4A** four different lines are shown. The upper line represents the state of energy, or charging level, of the rechargeable energy storage system. The line immediately below the state of energy curve represents when charging is available. As can be seen in **FIG. 4A****,** charging is performed immediately when charging is available, and charging continues until the desired state of energy is reached.

The second line from the bottom represents the electricity price. This is initially high, but decreases some time after charging is completed. As a result, the charging cost (represented by the bottom line) will be calculated from the high initial electricity price.

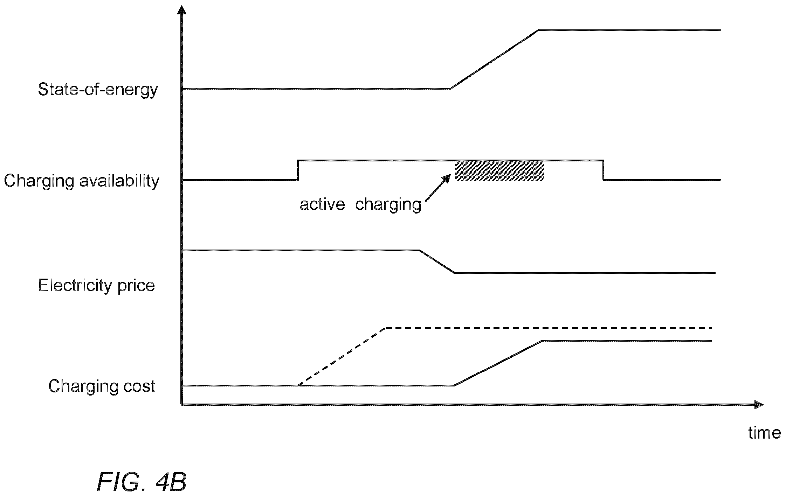

No turning to **FIG. 4B****,** the same lines are shown but in this example active charging is postponed until the electricity price has decreased to the minimum value. As a result, the charging cost will decrease as indicated by the bottom curve, where the charging cost for the example shown in **FIG. 4A** is illustrated by dashed lines.

It is understood that while the example in **FIG. 4B** results in an optimized charging cost, the example in **FIG. 4A** will be better in terms of downtime cost. Therefore, if the TCO is determined based on these two parameters only, an optimized charging strategy may be somewhere in between the two examples shown.

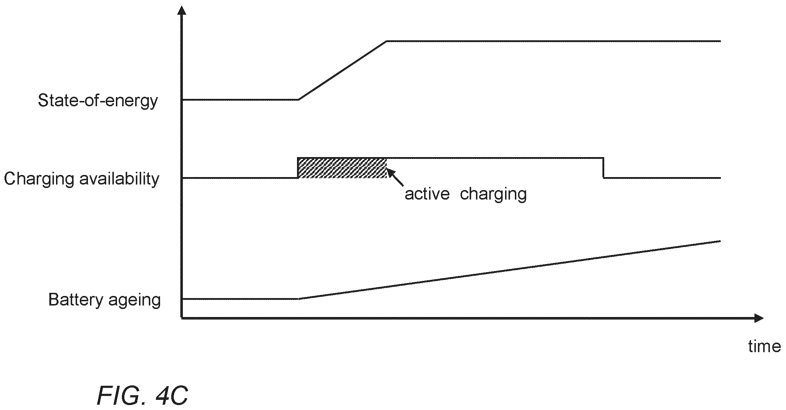

In **FIG. 4C** another example is shown. The upper two curves are similar to what is shown in **FIG. 4A****,** while the bottom curve represents battery ageing. Since battery ageing depends on the SOC of the battery, i.e. the energy level, ageing will increase at a certain rate during charging and while the SOC is maintained at a high level.

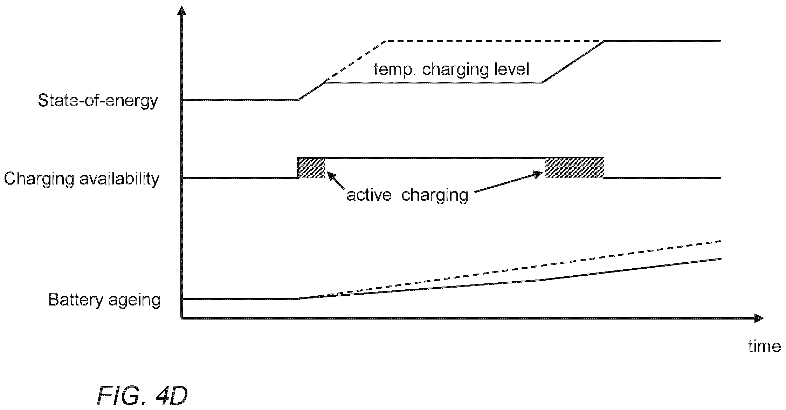

In **FIG. 4D** another example is shown, aimed to reduce the battery ageing. Here charging is split in two sequences, a first charging and a delayed second charging. Since the delayed second charging will postpone the SOC to reach its maximum value, ageing will be reduced. As for the diagram shown in **FIG. 4B****,** in **FIG. 4D** the ageing curve from the example of **FIG. 4C** is shown in dashed line.

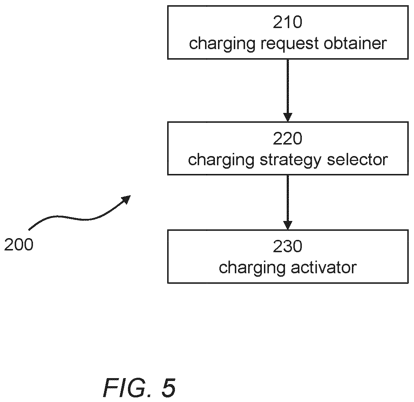

**FIG. 5** is an exemplary system diagram of a charging control system **200** according to an example. The charging control system **200** comprises a charging request obtainer **210** configured to obtain a charging request. The charging control system **200** also comprises a charging strategy selector **220** configured to select a charging strategy that is optimized with regards to the total cost of ownership of an associated rechargeable energy storage system **11.** The charging control system **200** further comprises a charging activator **230** configured to activate charging of the associated rechargeable energy storage system **11** according to the selected charging strategy.

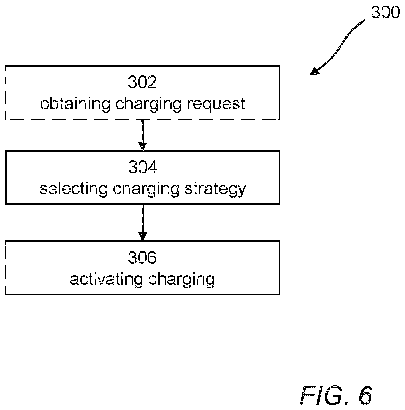

**FIG. 6** is a flow chart of a computer-implemented method **300** to perform charging of a rechargeable energy storage system **11** according to an example. The method **300** comprises obtaining **302,** by processing circuitry of a computer system, a charging request for a rechargeable energy storage system of a vehicle. The method **300** further comprises selecting **304,** by the processing circuitry, a charging strategy based on a total cost of ownership of the rechargeable energy storage system. The method **300** further comprises activating **306,** by the processing circuitry, charging of the rechargeable energy storage system according to the selected charging strategy.

**FIG. 7** is a schematic diagram of a computer system **400** for implementing examples disclosed herein. The computer system **400** is adapted to execute instructions from a computer-readable medium to perform these and/or any of the functions or processing described herein. The computer system **400** may be connected (e.g., networked) to other machines in a LAN (Local Area Network), LIN (Local Interconnect Network), automotive network communication protocol (e.g., FlexRay), an intranet, an extranet, or the Internet. While only a single device is illustrated, the computer system **400** may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, processing circuitry, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system **400** may comprise at least one computing device or electronic device capable of including firmware, hardware, and/or executing software instructions to implement the functionality described herein. The computer system **400** may include processing circuitry **402** (e.g., processing circuitry including one or more processor devices or control units), a memory **404,** and a system bus **406.** The computer system **400** may include at least one computing device having the processing circuitry **402.** The system bus **406** provides an interface for system components including, but not limited to, the memory **404** and the processing circuitry **402.** The processing circuitry **402** may include any number of hardware components for conducting data or signal processing or for executing computer code stored in memory **404.** The processing circuitry **402** may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry **402** may further include computer executable code that controls operation of the programmable device.

The system bus **406** may be any of several types of bus structures that may further interconnect to a memory bus (with or without a memory controller), a peripheral bus, and/or a local bus using any of a variety of bus architectures. The memory **404** may be one or more devices for storing data and/or computer code for completing or facilitating methods described herein. The memory **404** may include database components, object code components, script components, or other types of information structure for supporting the various activities herein. Any distributed or local memory device may be utilized with the systems and methods of this description. The memory **404** may be communicably connected to the processing circuitry **402** (e.g., via a circuit or any other wired, wireless, or network connection) and may include computer code for executing one or more processes described herein. The memory **404** may include non-volatile memory **408** (e.g., read-only memory (ROM), erasable programmable read-only memory (EPROM), electrically erasable programmable read-only memory (EEPROM), etc.), and volatile memory **410** (e.g., random-access memory (RAM)), or any other medium which can be used to carry or store desired program code in the form of machine-executable instructions or data structures and which can be accessed by a computer or other machine with processing circuitry **402.** A basic input/output system (BIOS) **412** may be stored in the non-volatile memory **408** and can include the basic routines that help to transfer information between elements within the computer system **400.**

The computer system **400** may further include or be coupled to a non-transitory computer-readable storage medium such as the storage device **414,** which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device **414** and other drives associated with computer-readable media and computer-usable media may provide non-volatile storage of data, data structures, computer-executable instructions, and the like.

Computer-code which is hard or soft coded may be provided in the form of one or more modules. The module(s) can be implemented as software and/or hard-coded in circuitry to implement the functionality described herein in whole or in part. The modules may be stored in the storage device **414** and/or in the volatile memory **410,** which may include an operating system **416** and/or one or more program modules **418.** All or a portion of the examples disclosed herein may be implemented as a computer program **420** stored on a transitory or non-transitory computer-usable or computer-readable storage medium (e.g., single medium or multiple media), such as the storage device **414,** which includes complex programming instructions (e.g., complex computer-readable program code) to cause the processing circuitry **402** to carry out actions described herein. Thus, the computer-readable program code of the computer program **420** can comprise software instructions for implementing the functionality of the examples described herein when executed by the processing circuitry **402.** In some examples, the storage device **414** may be a computer program product (e.g., readable storage medium) storing the computer program **420** thereon, where at least a portion of a computer program **420** may be loadable (e.g., into a processor) for implementing the functionality of the examples described herein when executed by the processing circuitry **402.** The processing circuitry **402** may serve as a controller or control system for the computer system **400** that is to implement the functionality described herein.

The computer system **400** may include an input device interface **422** configured to receive input and selections to be communicated to the computer system **400** when executing instructions, such as from a keyboard, mouse, touch-sensitive surface, etc. Such input devices may be connected to the processing circuitry **402** through the input device interface **422** coupled to the system bus **406** but can be connected through other interfaces, such as a parallel port, an Institute of Electrical and Electronic Engineers (IEEE) 1394 serial port, a Universal Serial Bus (USB) port, an IR interface, and the like. The computer system **400** may include an output device interface **424** configured to forward output, such as to a display, a video display unit (e.g., a liquid crystal display (LCD) or a cathode ray tube (CRT)). The computer system **400** may include a communications interface **426** suitable for communicating with a network as appropriate or desired.

The operational actions described in any of the exemplary aspects herein are described to provide examples and discussion. The actions may be performed by hardware components, may be embodied in machine-executable instructions to cause a processor to perform the actions, or may be performed by a combination of hardware and software. Although a specific order of method actions may be shown or described, the order of the actions may differ. In addition, two or more actions may be performed concurrently or with partial concurrence.

**Example 1:** A computer system comprising processing circuitry configured to: obtain a charging request for a rechargeable energy storage system (11) of a vehicle (1); select a charging strategy based on a total cost of ownership (TCO) of the rechargeable energy storage system (11); and activate charging of the rechargeable energy storage system (11) according to the selected charging strategy.

**Example 2:** The computer system of Example 1, wherein the processing circuitry is further configured to: obtain the charging request based on a driver request, a charging availability, and/or a current state of charge (SOC) of the rechargeable energy storage system (11).

**Example 3:** The computer system of any of Examples 1-2, wherein the processing circuitry is further configured to: obtain an electricity price, and determine the total cost of ownership (TCO) based on the obtained electricity price.

**Example 4:** The computer system of any of Examples 1-3, wherein the processing circuitry is further configured to: obtain a charging availability and/or a charging capability, and determine the total cost of ownership (TCO) based on the obtained charging availability and/or the obtained charging capability.

**Example 5:** The computer system of any of Examples 1-4, wherein the processing circuitry is further configured to: obtain a requested departure time and a requested itinerary for the vehicle (11), and determine the total cost of ownership (TCO) based on the obtained requested departure time and/or the requested itinerary.

**Example 6:** The computer system of any of Examples 1-5, wherein the processing circuitry is further configured to: obtain a state of health (SOH) behaviour for the rechargeable energy storage system (11), and determine the total cost of ownership (TCO) based on the obtained state of health (SOH) behaviour.

**Example 7:** The computer system of any of Examples 1-6, wherein the processing circuitry is further configured to: determine a plurality of charging strategies and an associated total cost of ownership (TCO) for each determined charging strategy; wherein the selected charging strategy is associated with the lowest total cost of ownership (TCO) of the rechargeable energy storage system.

**Example 8:** The computer system of Example 1, wherein the processing circuitry is further configured to: obtain the charging request based on a driver request, a charging availability, and/or a current state of charge (SOC) of the rechargeable energy storage system (11); obtain an electricity price, a charging availability and/or a charging capability, a requested departure time and a requested itinerary for the vehicle (11), a state of health (SOH) behaviour for the rechargeable energy storage system (11), and a current vehicle state, and determine the total cost of ownership (TCO) based on the obtained electricity price, based on the obtained charging availability and/or the obtained charging capability, based on the obtained requested departure time and/or the requested itinerary, based on the obtained state of health (SOH) behaviour, and based on the current vehicle state, wherein the processing circuitry is further configured to: determine a plurality of charging strategies and an associated total cost of ownership (TCO) for each determined charging strategy; wherein the selected charging strategy is associated with the lowest total cost of ownership (TCO) of the rechargeable energy storage system (11).

**Example 9:** A vehicle (1) comprising the computer system of any of Examples 1-8.

**Example 10:** The vehicle (1) of Example 9, further comprising at least one rechargeable energy storage system (11).

**Example 11:** A computer-implemented method, comprising: obtaining (302), by processing circuitry of a computer system, a charging request for a rechargeable energy storage system (11) of a vehicle (1); selecting (304), by the processing circuitry, a charging strategy based on a total cost of ownership (TCO) of the rechargeable energy storage system (11); and activating (306), by the processing circuitry, charging of the rechargeable energy storage system (11) according to the selected charging strategy.

**Example 12:** The method of Example 11, further comprising: obtaining (302), by the processing circuitry, the charging request based on a driver request, a charging availability, and/or a current state of charge of the rechargeable energy storage system (11).

**Example 13:** The method any of Examples 11-12, further comprising: obtaining, by the processing circuitry, an electricity price, and determining, by the processing circuitry, the total cost of ownership (TCO) based on the obtained electricity price.

**Example 14:** The method of any of Examples 11-13, further comprising: obtaining, by the processing circuitry, a charging availability and/or a charging capability, and determining, by the processing circuitry, the total cost of ownership (TCO) based on the obtained charging availability and/or the obtained charging capability.

**Example 15:** The method of any of Examples 11-14, further comprising: obtaining, by the processing circuitry, a requested departure time and a requested itinerary for the vehicle (1), and determining, by the processing circuitry, the total cost of ownership (TCO) based on the obtained requested departure time and/or the requested itinerary.

**Example 16:** The method of any of Examples 11-15, further comprising: obtaining, by the processing circuitry, a state of health behaviour for the rechargeable energy storage system (11), and determining, by the processing circuitry, the total cost of ownership (TCO) based on the obtained state of health behaviour.

**Example 17:** The method of any of Examples 11-16, further comprising: obtaining, by the processing circuitry, a current vehicle state for the vehicle (1), and determining, by the processing circuitry, the total cost of ownership (TCO) based on the obtained vehicle state.

**Example 18:** The method of any of Examples 11-17, wherein the processing circuitry is further configured to: determining, by the processing circuitry, a plurality of charging strategies and an associated total cost of ownership (TCO) for each determined charging strategy; wherein the selected charging strategy is associated with the lowest total cost of ownership (TCO) of the rechargeable energy storage system (11).

**Example 19:** A computer program product comprising program code for performing, when executed by the processing circuitry, the method of any of Examples 11-18.

**Example 20:** A non-transitory computer-readable storage medium comprising instructions, which when executed by the processing circuitry, cause the processing circuitry to perform the method of any of Examples 11-18.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

## Claims

1. A computer system comprising processing circuitry configured to:
obtain a charging request for a rechargeable energy storage system (11) of a vehicle (1);
select a charging strategy based on a total cost of ownership (TCO) of the rechargeable energy storage system (11); and
activate charging of the rechargeable energy storage system (11) according to the selected charging strategy.

2. The computer system of claim 1, wherein the processing circuitry is further configured to:
obtain the charging request based on a driver request, a charging availability, and/or a current state of charge (SOC) of the rechargeable energy storage system (11).

3. The computer system of any of claims 1-2, wherein the processing circuitry is further configured to:
obtain an electricity price, and
determine the total cost of ownership (TCO) based on the obtained electricity price.

4. The computer system of any of claims 1-3, wherein the processing circuitry is further configured to:
obtain a charging availability and/or a charging capability, and
determine the total cost of ownership (TCO) based on the obtained charging availability and/or the obtained charging capability.

5. The computer system of any of claims 1-4, wherein the processing circuitry is further configured to:
obtain a requested departure time and a requested itinerary for the vehicle (11), and
determine the total cost of ownership (TCO) based on the obtained requested departure time and/or the requested itinerary.

6. The computer system of any of claims 1-5, wherein the processing circuitry is further configured to:
obtain a state of health (SOH) behaviour for the rechargeable energy storage system (11), and
determine the total cost of ownership (TCO) based on the obtained state of health (SOH) behaviour.

7. The computer system of any of claims 1-6, wherein the processing circuitry is further configured to:
determine a plurality of charging strategies and an associated total cost of ownership (TCO) for each determined charging strategy; wherein
the selected charging strategy is associated with the lowest total cost of ownership (TCO) of the rechargeable energy storage system.

8. The computer system of claim 1, wherein the processing circuitry is further configured to:
obtain the charging request based on a driver request, a charging availability, and/or a current state of charge (SOC) of the rechargeable energy storage system (11);
obtain an electricity price, a charging availability and/or a charging capability, a requested departure time and a requested itinerary for the vehicle (11), a state of health (SOH) behaviour for the rechargeable energy storage system (11), and a current vehicle state, and
determine the total cost of ownership (TCO) based on the obtained electricity price, based on the obtained charging availability and/or the obtained charging capability, based on the obtained requested departure time and/or the requested itinerary, based on the obtained state of health (SOH) behaviour, and based on the current vehicle state, wherein the processing circuitry is further configured to:
determine a plurality of charging strategies and an associated total cost of ownership (TCO) for each determined charging strategy; wherein
the selected charging strategy is associated with the lowest total cost of ownership (TCO) of the rechargeable energy storage system (11).

9. A vehicle (1) comprising the computer system of any of claims 1-8.

10. The vehicle (1) of claim 9, further comprising at least one rechargeable energy storage system (11).

11. A computer-implemented method, comprising:
obtaining (302), by processing circuitry of a computer system, a charging request for a rechargeable energy storage system (11) of a vehicle (1);
selecting (304), by the processing circuitry, a charging strategy based on a total cost of ownership (TCO) of the rechargeable energy storage system (11); and
activating (306), by the processing circuitry, charging of the rechargeable energy storage system (11) according to the selected charging strategy.

12. The method of claim 11, further comprising:
obtaining (302), by the processing circuitry, the charging request based on a driver request, a charging availability, and/or a current state of charge of the rechargeable energy storage system (11).

13. The method of any of claims 11-12, wherein the processing circuitry is further configured to:
determining, by the processing circuitry, a plurality of charging strategies and an associated total cost of ownership (TCO) for each determined charging strategy; wherein
the selected charging strategy is associated with the lowest total cost of ownership (TCO) of the rechargeable energy storage system (11).

14. A computer program product comprising program code for performing, when executed by the processing circuitry, the method of any of claims 11-13.

15. A non-transitory computer-readable storage medium comprising instructions, which when executed by the processing circuitry, cause the processing circuitry to perform the method of any of claims 11-13.
